# EUROPEAN PATENT APPLICATION

(11) **EP 4 625 494 A1**
(43) Date of publication of application: **01.10.2025**
(21) Application number: 23893868.2
(22) Date of filing: 21.11.2023
(51) Int. Cl.: H01L 25/075, H01L 33/50

(54) **NEAR-NATURAL-LIGHT LED LIGHT SOURCE AND LIGHTING APPARATUS**

(30) Priority: 21.11.2022 CN 202211456881
(71) Applicant: Sichuan Wholelight Technology Development Co., Ltd, Chengdu, Sichuan 610000 (CN)
(72) Inventor: YANG, Xiaoqin, Chengdu, Sichuan 610000 (CN); ZENG, Sheng, Chengdu, Sichuan 610000 (CN); ZENG, Jiaoyang, Chengdu, Sichuan 610000 (CN); CHEN, Hua, Chengdu, Sichuan 610000 (CN); LI, Gang, Chengdu, Sichuan 610000 (CN); CHEN, Daorong, Chengdu, Sichuan 610000 (CN); ZENG, Xiaodong, Chengdu, Sichuan 610000 (CN)
(74) Representative: Cabinet Netter
(86) International application number: PCT/CN2023/133087
(87) International publication number: WO 2024/109778

(57) **Abstract**

The present application relates to the technical field of light source technology, and provides a near-natural light LED light source and an illuminating device. The near-natural light LED light source includes a substrate, at least one light-emitting assembly arranged on the substrate, and an electrical connector electrically connected to the light-emitting assembly. The light-emitting assembly includes at least three light-emitting units, each light-emitting unit comprises a blue light chip and a wavelength conversion element formed on a light-emitting side of the blue light chip, peak wavelengths of at least two of the blue light chips in a same light-emitting assembly differ by more than 3nm, light emitted by all of the light-emitting units in the same light-emitting assembly are mixed to form a near-natural light with a wavelength of 400-700nm, and an absolute spectral power of a 640-700nm band in the near-natural light is greater than 0.7. The near-natural light LED light source and the illuminating device provided in the present application can emit near-natural light, and the red light spectrum is saturated.

## Description

The present application claims priority of the Chinese patent application with application No. 202211456881.9, entitled "Near-natural light LED light source and illuminating device", submitted to CNIPA on November 21, 2022, and the entire contents of which are incorporated by reference in the present application.

### TECHNICAL FIELD

The present application relates to the technical field of light source technology, and more particularly to a near-natural light LED light source and an illuminating device.

### BACKGROUND

LED light sources are popular because of their advantages such as energy saving, environmental protection, and high brightness. However, the light emitted by existing LED light sources always makes people feel unnatural and uncomfortable. The main reasons are: firstly, the red light spectrum in the light is too weak, which causes the ciliary muscle to be often pulled forward, and the eyes are prone to myopia. Secondly, compared with the natural light that makes people comfortable, its spectrum is incomplete and the color rendering is poor.

In order to pursue a more comfortable illuminating effect, many research institutions are committed to developing light sources close to natural light, for example, using blue light chips combined with phosphors to obtain white light sources, or using red, green and blue primary color chips to mix light to obtain white light. When a blue light chip is combined with phosphor, the wavelength range of the chip and the wavelength range of the phosphor are limited, so its spectrum is still not ideal, especially the proportion of blue light is too high. The combination structure of red, green and blue chips also produces white light, but only the intensity at the three central wavelengths is large, while the other bands are too low, and the proportion of blue light is higher.

In addition, there are white light LED products that are arranged into a larger fluorescent body through a variety of fluorescent modules, each of the fluorescent modules corresponds to a wavelength, and cooperates with a blue light chip. Different fluorescent modules produce different lights, and then the lights are mixed to obtain white light. This structure is difficult to achieve uniform light mixing, and it is extremely difficult to debug near-natural light. Moreover, the structure is complex, the volume is large, and the applicability is poor.

### TECHNICAL PROBLEM

The objective of the present application is to provide a near-natural light LED light source and an illuminating device, which aims to solve the technical problems of too weak red light spectrum and incomplete spectrum in the prior art.

### TECHNICAL SOLUTION

The present application is implemented as follows. In the first aspect, a near-natural light LED light source is provided, which includes a substrate, at least one light-emitting assembly arranged on the substrate, and an electrical connector electrically connected to the light-emitting assembly. The light-emitting assembly includes at least three light-emitting units, each light-emitting unit comprises a blue light chip and a wavelength conversion element formed on a light-emitting side of the blue light chip, peak wavelengths of at least two of the blue light chips in a same light-emitting assembly differ by more than 3nm, light emitted by all of the light-emitting units in the same light-emitting assembly are mixed to form a near-natural light with a wavelength of 400-700nm, and an absolute spectral power of a 640-700nm band in the near-natural light is greater than 0.7.

In one embodiment, peak wavelengths of all the blue light chips in the same light-emitting assembly are different, and a peak wavelength interval between any two of the blue light chips is more than 3nm.

In one embodiment, each light-emitting unit enables to emit near-natural light with a wavelength of 400-700nm.

In one embodiment, the wavelength conversion element includes a fluorescent body.

In one embodiment, a fluorescent composition is mixed in the fluorescent body, and the fluorescent composition includes:
a first phosphor, an emission wavelength of the first phosphor is 480-500nm;
a second phosphor, an emission wavelength of the second phosphor is greater than 500nm and less than 620nm;
a third phosphor, an emission wavelength of the third phosphor is greater than or equal to 620nm; and
a mass ratio of the first phosphor, the second phosphor, and the third phosphor is (15-70): (15-70): (13-70).

In one embodiment, the first phosphor includes a phosphor A, and an emission wavelength of the phosphor A is 488-492nm;
the second phosphor includes a phosphor B, and an emission wavelength of the phosphor B is 523-542nm;
the third phosphor includes a phosphor C, a phosphor D, a phosphor E, and a phosphor F, an emission wavelength of the phosphor C is 628-681nm, an emission wavelength of the phosphor D is 718-722nm, an emission wavelength of the phosphor E is 738-742nm, and an emission wavelength of the phosphor F is 793-797nm.

In one embodiment, the first phosphor, the second phosphor, and the third phosphor are arranged separately;
the phosphor B in the second phosphor includes a phosphor B1 and a phosphor B2, and an emission wavelength of the phosphor B1 is 523-527nm, an emission wavelength of the phosphor B2 is 538-542nm, and a mass ratio of the phosphor B1 to the phosphor B2 is (20-85): (10-85); and
the phosphor C in the third phosphor includes a phosphor C1, a phosphor C2, and a phosphor C3, and an emission wavelength of the phosphor C1 is 628-632nm, an emission wavelength of the phosphor C2 is 658-662nm, and an emission wavelength of the phosphor C3 is 677-681nm; a mass ratio of the phosphor C1, the phosphor C2, the phosphor C3, the phosphor D, the phosphor E, and the phosphor F is (3-35): (1-45): (3-60): (7-90): (7-60): (1-70).

In one embodiment, the phosphor C in the third phosphor, the first phosphor and the second phosphor form a first mixture;
the phosphor D, the phosphor E, and the phosphor F in the third phosphor form a second mixture,
a mass ratio of the phosphor A, the phosphor B and the phosphor C in the first mixture is (10-80): (15-85): (1-40);
a mass ratio of the phosphor D, the phosphor E and the phosphor F in the second mixture is (20-120): (10-90): (1-100); and
the first mixture and the second mixture are arranged separately.

In one embodiment, the fluorescent body includes a first fluorescent portion, a second fluorescent portion, and a third fluorescent portion sequentially arranged along a light emission direction, the first fluorescent portion includes the first phosphor, the second fluorescent portion includes the second phosphor, and the third fluorescent portion includes the third phosphor.

In one embodiment, the fluorescent body includes a fourth fluorescent portion and a fifth fluorescent portion sequentially arranged along a light emission direction, the fourth fluorescent portion includes the first mixture, and the fifth fluorescent portion includes the second mixture.

In one embodiment, a refractive index of each fluorescent portion arranged along the light emission direction increases sequentially.

In one embodiment, a thickness of each fluorescent portion is greater than a particle size of any one of the phosphors, and less than 1.5 times a maximum particle size of a phosphor in the fluorescent portion.

In one embodiment, a thickness of the fluorescent body is less than or equal to 0.3 mm.

In one embodiment, the near-natural light has following optical parameters:
when a color temperature of the near-natural light is 2700K-3000K, an absolute spectral power of a 380-435nm band is less than 0.35; an absolute spectral power of a 435-475nm band is greater than 0.40; an absolute spectral power of a 475-492nm band is greater than 0.45; an absolute spectral power of a 492-577nm band is greater than 0.50; an absolute spectral power of a 577-597nm band is greater than 0.75; an absolute spectral power of a 597-622nm band is greater than 0.80; and an absolute spectral power of a 622-700nm band is greater than 0.80;
when the color temperature of the near-natural light is 4000K-4200K, the absolute spectral power of the 380-435nm band is less than 0.40; the absolute spectral power of the 435-475nm band is less than 0.65; the absolute spectral power of the 475-492nm band is greater than 0.60; the absolute spectral power of the 492-577nm band is greater than 0.65; the absolute spectral power of the 577-597nm band is greater than 0.80; the absolute spectral power of the 597-622nm band is greater than 0.8; and the absolute spectral power of the 622-700nm band is greater than 0.80;
when the color temperature of the near-natural light is 5500K-6000K, the absolute spectral power of the 380-435nm band is less than 0.45; the absolute spectral power of the 435-475nm band is less than 0.80; the absolute spectral power of the 475-492nm band is greater than 0.70; the absolute spectral power of the 492-577nm band is greater than 0.80; the absolute spectral power of the 577-597nm band is greater than 0.80; the absolute spectral power of the 597-622nm band is greater than 0.80; and the absolute spectral power in the 622-700nm band is greater than 0.70; and
when the color temperature of the near-natural light is less than 4000K, the absolute spectral power of the 380-435nm band is less than 0.40; the absolute spectral power of the 435-475nm band is less than 0.65; the absolute spectral power of the 475-492nm band is greater than 0.30; the absolute spectral power of the 492-577nm band is less than 0.7; the absolute spectral power of the 577-597nm band is less than 0.80; the absolute spectral power of the 597-622nm band is greater than 0.8; and the absolute spectral power of the 622-700nm band is greater than 0.80.

In one embodiment, the same light-emitting unit includes a plurality of blue light chips, and the peak wavelengths of all the blue light chips in the same light-emitting unit are consistent, or a difference in the peak wavelengths of any two blue light chips is within a preset range.

In one embodiment, the blue light chips are mounted on a surface of the substrate in a flip-chip manner.

In one embodiment, the wavelength conversion element is a fluorescent film, and the fluorescent film is formed on a light-emitting surface of the blue light chip by spraying.

In one embodiment, the blue light chips are mounted on the substrate by a CSP packaging process.

In one embodiment, the blue light chips are mounted on a surface of the substrate layer in a face-up manner.

In one embodiment, a reflective cup corresponding to each of the light-emitting units is provided on the substrate, each of the light-emitting units is arranged in one corresponding reflective cup, and the electrical connector is formed on the surface of the substrate and connected to the blue light chip at a bottom of the reflective cup.

In one embodiment, a first encapsulation layer is filled between the blue light chip and the wavelength conversion element in each of the light-emitting units; or
a first encapsulation layer is filled between the blue light chip and the wavelength conversion element in each of the light-emitting units, and a light-emitting surface of the wavelength conversion element is covered with a second encapsulation layer.

In one embodiment, the light-emitting assembly includes the three light-emitting units that are spaced apart and distributed in a triangular shape; or
all the light-emitting units in the same light-emitting assembly are arranged in a straight line.

In one embodiment, a thickness of the fluorescent body is less than or equal to 0.3 mm.
a spacing between two adjacent light-emitting units is greater than the thickness of the fluorescent body.

In a second aspect, an illuminating device is provided, which includes the near-natural light LED light source according to any one of above embodiments.

Compared to the prior art, the technical effect of the first aspect of the present application is:
First, each light-emitting assembly in the near-natural light LED light source provided by the embodiment of the present application obtains a full-color bionic spectrum that is closer to natural light by combining at least three light-emitting units. Compared with traditional white light illuminating, the wavelength of near-natural light is more complete, the relative spectral power of each band is closer to natural light, and the visual experience is more comfortable.
Second, the absolute spectral power of red light is improved, especially the red light of 640-700nm band has the effect of promoting eye blood circulation and preventing eye fatigue. At the same time, the saturation of the red light of 640-700nm band will not pull the ciliary muscle forward all the time to cause the eye axis to shorten, which can improve the health level of near-natural light illuminating.
Third, at least three light-emitting units are used in combination, with a simple structure and good variable controllability during the debugging process, so that the debugging of near-natural light can be realized, to solve the problem that multiple light-emitting members cannot adjust near-natural light, and the problem that near-natural light cannot be obtained by combining blue light chips and the fluorescent glue.
Fourth, the peak wavelengths of at least two blue light chips in the same light-emitting assembly differ by more than 3nm, which reduces the blue light while increasing the light power of cyan light, the long-standing problem of low cyan light in near-natural light research is solved, so that the full-color bionic spectrum is closer to real natural light, and further improves the color rendering index.
Fifth, the light-emitting unit can adopt a micro-light-emitting body that meets the performance requirements, and the light source is a micro-lamp bead as a whole. Multiple lamp beads can be arranged on the substrate of various lamps in any form. Due to the small size, the lamp beads can be arranged at any position of the substrate, which is flexible in application, and the overall light emission of the lamp is uniform and the illuminating effect is good.
Sixth, this combination of multiple light-emitting units, each of which has the packaging technology of the wavelength conversion element, a continuous, wide-spectrum color light can also be achieved, which is dedicated to physiotherapy products, and solves the technical bottleneck of the single wavelength and narrow spectrum of the color light source in the industry.

It can be understood that the beneficial effects of the above-mentioned second aspect can be referred to the relevant description in the above-mentioned first aspect, which will not be repeated here.

### DESCRIPTION OF THE DRAWINGS

In order to more clearly illustrate the technical solution of the embodiment of the present application, the drawings required to be used in the embodiment of the present application or the prior art description will be briefly introduced below. Obviously, the drawings described below are only some embodiments of the present application. For those skilled in the art, other drawings can also be obtained based on these drawings without creative work.
FIG. 1 is a schematic diagram of a top view of a near-natural light LED light source provided in an embodiment of the present application;
FIG. 2 is a schematic diagram of a cross-sectional structure of one of the light-emitting units in FIG. 1;
FIG. 3 is a comparison diagram of the spectrum formed by a near-natural light LED light source provided in an embodiment of the present application and the spectrum formed by the ordinary light source; (a) in FIG. 3 is the spectrum formed by the near-natural light LED light source provided in the embodiment of the present application, and (b) in FIG. 3 is the spectrum formed by the ordinary light source;
FIG. 4 is a spectrum diagram formed by each light-emitting unit in the light-emitting assembly used in an embodiment of the present application;
FIG. 5 is a comparison diagram of the spectrum generated by ta near-natural light LED light source provided in an embodiment of the present application under different drive currents;
FIG. 6 is a schematic diagram of a side view structure of a wavelength conversion element used in an embodiment of the present application;
FIG. 7 is a spectrum diagram of a near-natural light LED light source provided in Embodiment 1;
FIG. 8 is a spectrum diagram of a near-natural light LED light source provided in Embodiment 2;
FIG. 9 is a spectrum diagram of a near-natural light LED light source provided in Embodiment 3;
FIG. 10 is a spectrum diagram of a near-natural light LED light source provided in Embodiment 4;
FIG. 11 is a spectrum diagram of a near-natural light LED light source provided in Embodiment 5
FIG. 12 is a spectrum diagram of a near-natural light LED light source provided in Embodiment 6;
FIG. 13 is a spectrum diagram of a near-natural light LED light source provided in Embodiment 7;
FIG. 14 is a spectrum diagram of a near-natural light LED light source provided in Embodiment 8;
FIG. 15 is a schematic diagram of a cross-sectional structure of a first fluorescent portion used in an embodiment of the present application;
FIG. 16 is a schematic diagram of a top view of a near-natural light LED light source provided in another embodiment of the present application;
FIG. 17 is a schematic diagram of a cross-sectional structure of one of the light-emitting units in FIG. 16;
FIG. 18 is a schematic diagram of a top view of a near-natural light LED light source provided in another embodiment of the present application;
FIG. 19 is a schematic diagram of a cross-sectional structure of one of the light-emitting units in FIG. 18;
FIG. 20 is a schematic diagram of an encapsulation structure of a single light-emitting unit used in an embodiment of the present application;
FIG. 21 is a schematic diagram of an encapsulation structure of a single light-emitting unit used in another embodiment of the present application;
FIG. 22 is a schematic diagram of an encapsulation structure of a single light-emitting unit used in another embodiment of the present application; and
FIG. 23 is a schematic diagram of an encapsulation structure of a single light-emitting unit used in another embodiment of the present application.

The reference numerals are listed:
100-substrate; 200-electrical connector; 300-light-emitting unit; 310-blue light chip; 320-wavelength conversion element; 321-first fluorescent portion; 3211-colloid; 3212-phosphor; 322,-second fluorescent portion; 323-third fluorescent portion; 330-protective layer; 340-transparent encapsulation layer; 400-reflective cup; 500-first encapsulation layer; 600-second encapsulation layer; d1-thickness of fluorescent portion; d2-particle size of phosphor; d3-thickness of fluorescent body; d4-spacing between two adjacent light-emitting units.

### DETAILED DESCRIPTION OF EMBODIMENTS

The embodiments of the present application are described in detail below, and examples of the embodiments are shown in the accompanying drawings, in which an always unchanged reference number or similar reference numbers represent(s) identical or similar components or components having identical or similar functionalities. The embodiment described below with reference to the accompanying figures is illustrative and intended to illustrate the present application, but should not be considered as any limitation to the present application.

In the description of the present application, it needs to be understood that, directions or location relationships indicated by terms such as "length", "width", "up", "down", "front", "rear", "left", "right", "vertical", "horizontal", "top", "bottom", "inside", "outside", and so on are the directions or location relationships shown in the accompanying figures, which are only intended to describe the present application conveniently and simplify the description, but not to indicate or imply that an indicated device or component must have specific locations or be constructed and manipulated according to specific locations; therefore, these terms shouldn't be considered as any limitation to the present application.

In addition, the terms "first" and "second" are only used for descriptive purposes, and cannot be understood as indicating or implying relative importance or implicitly indicating the number of technical features indicated. Therefore, the features defined as "first" and "second" may explicitly or implicitly include one or more of the features. In the description of the present application, "multiple" means two or more, unless otherwise clearly and specifically defined.

In the present application, unless there is additional explicit stipulation and limitation, terms such as "mount", "connect with each other", "connect", "fix", and so on should be generalizedly interpreted, for example, "connect" can be interpreted as being fixedly connected, detachably connected, or connected integrally; "connect" can also be interpreted as being mechanically connected or electrically connected; "connect" can be further interpreted as being directly connected or indirectly connected through intermediary, or being internal communication between two components or an interaction relationship between the two components. For the one of ordinary skill in the art, the specific meanings of the aforementioned terms in the present application can be interpreted according to specific conditions.

In order to make the purpose, technical solution and advantages of the present application clearer, the present application is further described in detail below in conjunction with the accompanying drawings and embodiments.

Explanation of technical terms:

### 1. Spectral power:

The spectrum emitted by a light source is often not a single wavelength, but is composed of mixed radiation of many different wavelengths. The spectral radiation of a light source in the order of wavelengths and the distribution of the intensity of each wavelength is called the spectral power distribution of the light source.

The parameters used to characterize the size of the spectral power are divided into absolute spectral power and relative spectral power. Then the absolute spectral power distribution curve refers to the curve drawn by the absolute value of the energy of various wavelengths of light radiated by the spectrum;
The relative spectral power distribution curve refers to the spectral power distribution curve that compares the energy of various wavelengths of the spectrum radiated by the light source and normalizes it so that the radiation power changes only within the specified range. The relative spectral power with the largest radiation power is 1, and the relative spectral power of other wavelengths is less than 1.

### 2. Color ratio:

Any white light can be obtained by mixing the three primary colors of red, green and blue in corresponding proportions. In order to express the relative proportion of the three primary colors of R, G and B in the total amount of white light, the chromaticity coordinates r, g and b are introduced, where r=R/(R+G+B), g= G/(R+G+B), b= B/(R+G+B), r+g+b=1, and r, g and b are the color ratio of red light, green light and blue light respectively.

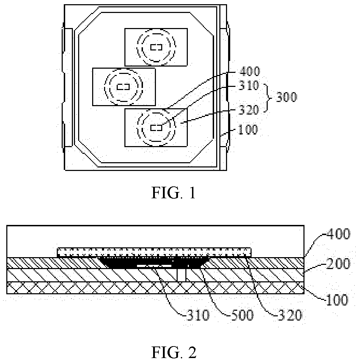

As shown in FIG. 1 and FIG. 2, in the embodiment of the present application, a near-natural light LED light source is provided, which can be used in various illuminating devices, including a substrate 100, at least one light-emitting assembly arranged on the substrate 100, and an electrical connector 200 electrically connected to the light-emitting assembly. The substrate 100 in the present embodiment can be a hard substrate such as a printed circuit board, an aluminum substrate, or a flexible substrate, which can be flexibly selected according to the use needs. The electrical connector 200 can be a circuit formed on the surface of the substrate 100, or an electrode mounted on the surface of the substrate 100. The connection method of the electrical connector 200 and the substrate 100 can be determined according to the material of the two and the mounting method of the light-emitting assembly, which is a prior art and will not be repeated here. Each light-emitting assembly is electrically connected to an external power source through the above-mentioned electrical connector 200. The light-emitting assembly includes at least three light-emitting units 300. Specifically, in the present embodiment, three, four or more light-emitting units 300 can be arranged in the same light-emitting assembly, and different light-emitting units 300 generally have a certain interval, or there can be no interval, which can be determined according to the light-emitting effect. When different light-emitting units 300 are arranged at intervals, the light-emitting efficiency of the light source is generally higher. At this time, the intervals between different light-emitting units 300 can be the same or different, and can be specifically arranged according to the light-emitting effect of the light source.

The light-emitting unit 300 includes a blue light chip 310 and a wavelength conversion element 320 formed on the light-emitting side of the blue light chip 310. The peak wavelengths of at least two blue light chips 310 in the same light-emitting assembly differ by more than 3nm. It should be noted that in this embodiment, one blue light chip 310 can be provided in the same light-emitting unit 300, or two or more blue light chips 310 can be provided. When two or more blue light chips 310 are provided in a single blue light chip 310, blue light chips 310 with the same peak wavelength or slight differences are generally used. The light emitted by all light-emitting units 300 in the same light-emitting assembly can be mixed to form near-natural light with a wavelength of 400-700nm, and the absolute spectral power of the 640-700nm band in the near-natural light is greater than 0.7.

For ease of description, the following content will refer to "near-natural light LED light source" as light source or this light source. Those skilled in the art should understand that the "light source", "this light source" and "near-natural light LED light source" in the following generally refer to the "near-natural light LED light source" in the embodiment.

The wavelength ranges of various colors of light in visible light are as follows: the wavelength of red light is 622-700nm, the wavelength of orange light is 597-622nm, the wavelength of yellow light is 577-597nm, the wavelength of green light is 492-577nm, the wavelength of cyan light is 475-492nm, the wavelength of blue light is 435-475nm, and the wavelength of purple light is 380-435nm. The 640-700nm band in the embodiment corresponds to the red light, which can penetrate 10mm below the skin and has the effect of promoting blood circulation in the eyes and preventing eye fatigue.

In the field of LED illuminating, studying illuminating sources close to the natural light is one of the development trends in this field, and it is also the direction that many researchers and institutions have been working hard on. There are also some illuminating products dedicated to approaching natural light in the prior art. The light generated by such products is usually called "near-natural light". The near-natural light refers to the spectral shape (relative spectral power of the corresponding band) is close to the natural light, and at least some optical parameters are close to the natural light. The degree of closeness is not limited to a certain value. The near-natural light LED light source in the embodiment is also intended to achieve an illuminating effect closer to the natural light, and can increase the absolute spectral power of red light.

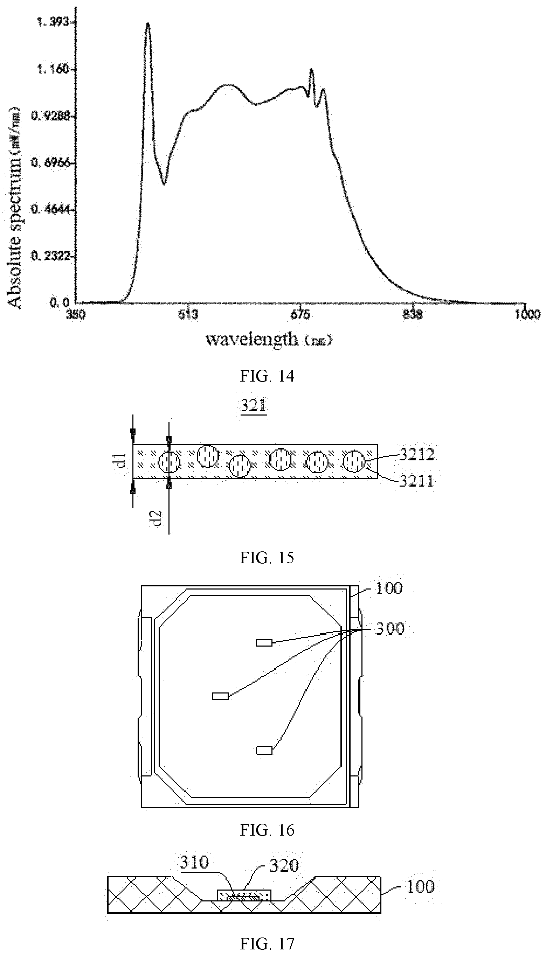

Specifically, the basic supporting structure of the light source is a substrate 100, and the light-emitting assembly is arranged on the substrate 100. The number of light-emitting assemblies is one group, two groups or more groups, and the structure and function of each light-emitting assembly are consistent. This embodiment is preferably a group. Each group of light-emitting assemblies includes at least three light-emitting units 300, that is, the light source emits near-natural light by mixing the lights emitted by at least three light-emitting units 300. As shown in FIG. 15, the light-emitting unit 300 includes a blue light chip 310 and a wavelength conversion element 320 formed on the light-emitting side of the blue light chip 310. The blue light chip 310 is used to emit blue light, and the wavelength conversion element 320 is used to convert the wavelength of the monochromatic light emitted by the blue light chip 310 to generate other colored light (which can be white light or other colors of light), and multiple colored lights are mixed to form near-natural light. Specifically, each light-emitting unit 300 in the embodiment can emit light with a full-color bionic spectrum, or light with a partial spectrum, as long as the light emitted by all light-emitting units 300 in the same light-emitting assembly can be mixed to form near-natural light with a wavelength of 400-700nm, and the absolute spectral power of the 640-700nm band in the near-natural light is greater than 0.7. Since each group of light-emitting assemblies can emit near-natural light, when the light source includes multiple groups of light-emitting assemblies, the light source can also emit near-natural light.

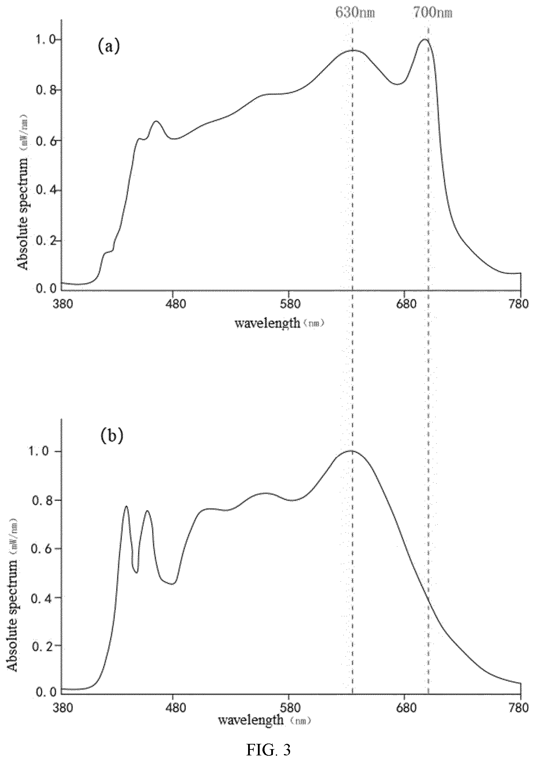

For ease of understanding, FIG. 3 shows a spectrum of near-natural light that can be achieved by the light source provided by the embodiment (such as (a) in FIG. 3) and a spectrum of light formed by an ordinary light source (such as (b) in FIG. 3). It can be seen from the figure that the spectrum of the near-natural light that can be achieved by the light source provided by the embodiment is complete, and the absolute spectral power of the 640-700nm band in the near-natural light in the spectrum is greater than 0.7, that is, the red light of 640-700nm band is saturated, which will not pull the ciliary muscle forward all the time, resulting in a shortened eye axis, and the health level of near-natural light illuminating can be improved. At the same time, it can be seen from the above spectrum that the proportion of blue light in the spectrum of the near-natural light that can be achieved by the light source provided by the embodiment is reduced, which is beneficial to protecting eyesight, especially the eyesight of infants and children, and is also beneficial to reducing sub-health problems caused by excessive blue light.

At the same time, the peak wavelengths of at least two blue light chips 310 located in the same light-emitting assembly differ by more than 3nm. Compared with the blue light chips 310 with the same peak wavelength, the absolute spectral power of the cyan light can be effectively improved, which solves the long-standing problem of low cyan light in the study of near-natural light, so that the quasi-natural light is closer to real natural light, and further improves the color rendering index.

The light source provided by the embodiment of the present application has at least the following effects:
First, each light-emitting assembly in the light source obtains a full-color bionic spectrum that is closer to natural light by combining at least three light-emitting units 300. Compared with traditional white light illuminating, the wavelength of near-natural light is more complete, the relative spectral power of each band is closer to natural light, and the visual experience is more comfortable.
Second, the absolute spectral power of red light is improved, especially the red light of 640-700nm band has the effect of promoting eye blood circulation and preventing eye fatigue. At the same time, the saturation of the red light of 640-700nm band will not pull the ciliary muscle forward all the time to cause the eye axis to shorten, which can improve the health level of near-natural light illuminating.
Third, at least three light-emitting units 300 are used in combination, with a simple structure and good variable controllability during the debugging process, so that the debugging of near-natural light can be realized, to solve the problem that multiple light-emitting members cannot adjust near-natural light, and the problem that near-natural light cannot be obtained by combining blue light chips and the fluorescent glue.
Fourth, the peak wavelengths of at least two blue light chips 310 in the same light-emitting assembly differ by more than 3nm, which reduces the blue light while increasing the light power of cyan light, the long-standing problem of low cyan light in near-natural light research is solved, so that the full-color bionic spectrum is closer to real natural light, and further improves the color rendering index.
Fifth, the light-emitting unit 300 can adopt a micro-light-emitting body that meets the performance requirements, and the light source is a micro-lamp bead as a whole. Multiple lamp beads can be arranged on the substrate of various lamps in any form. Due to the small size, the lamp beads can be arranged at any position of the substrate, which is flexible in application, and the overall light emission of the lamp is uniform and the illuminating effect is good.
Sixth, this combination of multiple light-emitting units 300, each of which has the packaging technology of the wavelength conversion element 320, a continuous, wide-spectrum color light can also be achieved, which is dedicated to physiotherapy products, and solves the technical bottleneck of the single wavelength and narrow spectrum of the color light source in the industry.

In the above embodiment, if there are at least two blue light chips with the same peak wavelength in the same light-emitting assembly, the absolute spectral power of the blue light in the spectrum formed by the near-natural light LED light source is small. In order to make up for this defect, in an optional embodiment, the peak wavelengths of all blue light chips in the same light-emitting assembly are different, and the peak wavelength interval between any two blue light chips is more than 3nm.

With this structure, after testing, the spectrum formed by the near-natural light LED light source is closer to the natural light spectrum, which can solve the problem of the small absolute spectral power of the blue light in the spectrum formed by the near-natural light LED light source.

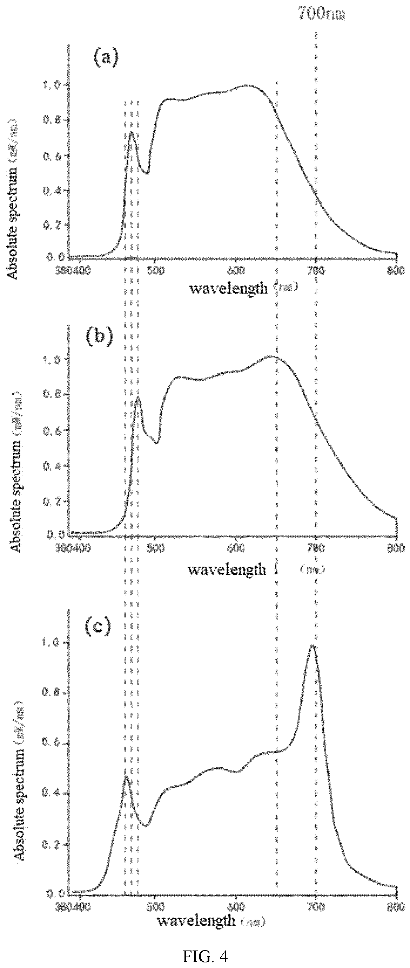

In an optional embodiment, each light-emitting unit can emit the near-natural light with a wavelength of 400-700nm. In the embodiment, different light-emitting units in the same light-emitting assembly can emit full-color bionic spectrum light, but the spectrum corresponding to each light-emitting unit is generally different. As shown in FIG. 4, when there are three light-emitting units in the light-emitting assembly, the spectrum corresponding to one of the light-emitting units can be shown in (a) of FIG. 4, the spectrum corresponding to one of the light-emitting units can be shown in (b) of FIG. 4, and the spectrum corresponding to the last light-emitting unit 300 can be shown in (c) of FIG. 4, so that the light emitted by the three light-emitting units can be mixed to form a near-natural light with a spectrum as shown in (a) of FIG. 3. In other embodiments, the light-emitting units can also form spectrum of other shapes, which are not limited here. Each light-emitting unit adopts a structure that can emit a full-color bionic spectrum, so that it easier for the entire light-emitting assembly to emit a full-color bionic spectrum near-natural light.

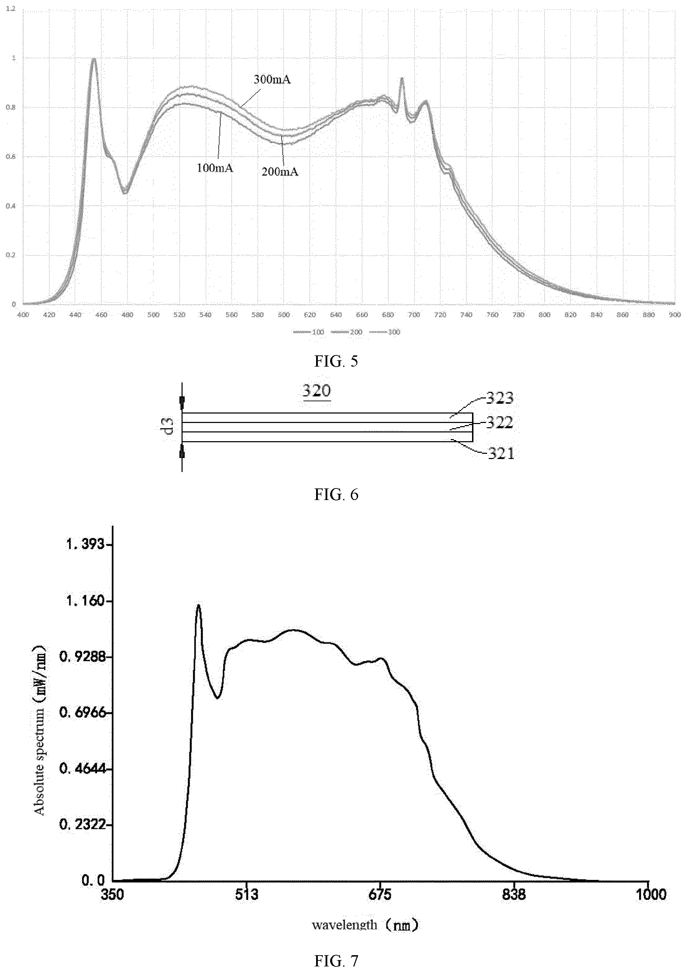

In addition, since each light-emitting unit in the embodiment is provided with a wavelength conversion element, according to the existing process, compared with the blue light chips in multiple light-emitting units sharing one wavelength conversion element, it is easier to keep the spectrum of each light-emitting unit stable and will not change due to changes in the drive current. As shown in FIG. 5, after testing, the light source provided in the embodiment has a small aberration in the spectral shape formed under three different drive currents (100mA, 200mA and 300mA), and the spectral stability is high.

As an optical transducer element, the wavelength conversion element can have various forms, including fluorescent color wheels, nonlinear optical crystals or fluorescent bodies. When the wavelength conversion element includes a fluorescent body, the structure is simple, which is convenient to control the size of the light source. Specifically, the fluorescent body can be a fluorescent film, fluorescent ceramics, fluorescent glass, etc. For ease of processing, the fluorescent body is preferred to a fluorescent film, a fluorescent coating, a fluorescent colloid, etc. These fluorescent structures are generally made by mixing phosphors in adhesives such as silica gel or epoxy resin. Specifically, when the blue light chip is horizontally mounted on the substrate, the fluorescent body can be a block structure formed after filling the entire reflective cup, or it can be a fluorescent layer sealed on the top of the reflective cup, and other forms can also be used according to actual use needs; when the blue light chip is mounted on the substrate in a flip-chip manner, the fluorescent body can be a fluorescent film, a fluorescent coating, and other structures. More specifically, when the blue light chip is prepared by flip-chip method, all blue light chips can be arranged in sequence, and then the fluorescent layer can be prepared on all blue light chips by spraying, printing, etc., and then each light-emitting unit can be prepared by cutting, and finally each light-emitting unit is assembled on the substrate and electrically connected to the electrical connector formed on the substrate.

The above-mentioned fluorescent body can be arranged in a variety of forms. For ease of understanding, examples are given.

In some embodiments, a fluorescent composition is mixed in the fluorescent body, and the fluorescent composition includes a first phosphor, a second phosphor, and a third phosphor. In which, the emission wavelength of the first phosphor is 480-500nm, the emission wavelength of the second phosphor is greater than 500nm and less than 620nm, and the emission wavelength of the third phosphor is greater than or equal to 620nm. The mass ratio of the first phosphor, the second phosphor, and the third phosphor is (15-70): (15-70): (13-70).

By cooperating with each other, the first phosphor, the second phosphor and the third phosphor, which have different emission wavelengths and are distributed in the visible light band, the fluorescent composition of the embodiment of the present application is excited to produce full-color white light. At the same time, by adjusting the mass ratio of the first phosphor, the second phosphor, and the third phosphor to (15-70): (15-70): (13-70), the absolute optical power value of the blue light in the white light is low, the absolute optical power value of the cyan light is high, and the natural light is highly simulated, while the color rendering index of the white light is improved.

It can be understood that the emission wavelength of the phosphor refers to the wavelength corresponding to the peak value of the main peak of the spectrum generated by the phosphor being excited by photons.

In some embodiments, the first phosphor includes a phosphor A; the emission wavelength of the phosphor A is 488-492nm. The second phosphor includes a phosphor B, and the emission wavelength of the phosphor B is 523-542nm. The third phosphor includes a phosphor C, a phosphor D, a phosphor E, and a phosphor F. The emission wavelength of the phosphor C is 628-681nm, the emission wavelength of the phosphor D is 718-722nm, the emission wavelength of the phosphor E is 738-742nm, and the emission wavelength of the phosphor F is 793-797nm.

The phosphor A, the phosphor B, the phosphor C, the phosphor E, and the phosphor F whose emission wavelengths are dispersed in the visible light band make the white light generated by the fluorescent composition of the present application contain visible light of all bands within the range of 400-800nm, so that the white light further simulates natural light.

In a further embodiment, the phosphor B includes a phosphor B1 and a phosphor B2, the emission wavelength of the phosphor B1 is 523-527nm, and the emission wavelength of the phosphor B2 is greater than 538-542nm. The Phosphor C includes a phosphor C1, a phosphor C2, and a phosphor C3. The emission wavelength of the phosphor C1 is 628-632nm, the emission wavelength of the phosphor C2 is 658-662nm, and the emission wavelength of the phosphor C3 is 677-681nm.

In the exemplary embodiment, the phosphor A includes A1 and A2, the emission wavelength of the phosphor A1 is 480nm; the emission wavelength of the phosphor A2 is 490nm. The specific emission wavelength of the phosphor B1 can be 525nm, the specific emission wavelength of the phosphor B2 can be 540nm, the specific emission wavelength of the phosphor C1 can be 630nm, the specific emission wavelength of the phosphor C2 can be 660nm, the specific emission wavelength of the phosphor C3 can be 679nm, the specific emission wavelength of the phosphor D can be 720nm, the specific emission wavelength of the phosphor E can be 740nm, and the specific emission wavelength of the phosphor F can be 795nm.

The first phosphor, the second phosphor, and the third phosphor can be separated from each other or mixed with each other. By making the first phosphor, the second phosphor, and the third phosphor include phosphor components with different emission wavelengths, the phosphors of different wavelengths in the bionic fluorescent composition of the embodiment of the present application can be flexibly adjusted according to needs. For example, in some embodiments, the mass ratio of the first phosphor, the second phosphor, and the third phosphor can be controlled to be (15-70): (15-70): (13-60), further to be (25-60): (25-55): (13-60), furthermore to be (31-40): (31-40): (13-60), the mass ratio of the phosphor B1 and the phosphor B2 in the second phosphor can also be controlled to be (20-85): (10-85), further to be (30-7 5): (20-75), furthermore to be (35-70): (25-70), and the mass ratio of the phosphor C1, the phosphor C2, the phosphor C3, the phosphor D, the phosphor E, and the phosphor F in the third phosphor can also be controlled to be (3-35): (1-45) (3-60): (7-90): (7-60): (1-70), further to be (7-30): (3-40) (3-50): (10-90): (10-60): (1-60), and furthermore to be (7-20): (3-30) (3-40): (20-80): (20-50): (1-50).

By controlling the mass ratio of the first phosphor, the second phosphor, and the third phosphor within the mass ratio of the components in the second phosphor and the third phosphor within this range, it is possible to adjusting the absolute optical power values of different wavelength bands of white light generated by the fluorescent composition of the present application, and can optimize the spectrum of the generated white light, such as the red light power of the white light in the wavelength range of 640-700nm is high, the white light is closer to natural light, the comfort of the white light when used for illuminating and the authenticity of the environment and objects is improved, and the harm to the human body is reduced.

In some embodiments, the phosphor C in the third phosphor, the first phosphor, and the second phosphor form a first mixture; the phosphor D, the phosphor E, and the phosphor F in the third phosphor form a second mixture, and the first mixture is arranged separately from the second mixture.

In a further embodiment, the emission wavelength of the phosphor A in the first mixture can be 490nm (A2), the phosphor B includes a phosphor B3, and the emission wavelength of the phosphor B3 can be 532-537nm, specifically can be 535nm, the phosphor C may include the phosphor C2 described above, and the emission wavelength of the phosphor C2 can be 658-662nm, specifically can be 660nm. The emission wavelength of the phosphor D in the second mixture can be 720nm, the emission wavelength of the phosphor E can be 740nm, and the emission wavelength of the phosphor F can be 795nm.

By dividing the fluorescent composition into the first mixture and the second mixture that are separately arranged, the first mixture and the second mixture contain components with different emission wavelengths, and when forming a film, the first mixture and the second mixture can be formed into films separately, so that the mass ratio of the first mixture and the second mixture can be flexibly adjusted, and then the spectrum of the white light emitted by the fluorescent composition can be adjusted to optimize the spectral distribution of the generated white light, so that the white light is closer to the natural light.

In some embodiments, the mass ratio of the phosphor A, the phosphor B, and the phosphor C in the first mixture can be controlled to be (10-80): (15-85): (1-40), further to be (10-70): (15-85): (1-35), and furthermore to be (15-60): (20-75): (1-30). The mass ratio of the phosphor D, the phosphor E, and the phosphor F in the second mixture can also be controlled to be (20-120): (10-90): (1-100), further to be (30-100): (15-70): (1-80), and furthermore to be (40-90): (20-60): (1-70).

By controlling the mass ratio of the first mixture and the second mixture, and the mass ratio of each component in the first mixture and the second mixture, the spectrum of the generated white light can be adjusted. Controlling the mass ratio of the first mixture and the second mixture, and the mass ratio of each component in the first mixture and the second mixture within this range can optimize the spectrum of the generated white light. For example, the mass ratio of the second mixture can be increased so that the red light power of the white light in the wavelength range of 640-700nm is higher and closer to the natural light.

In some embodiments, the phosphor A, the phosphor B, the phosphor C, the phosphor D, the phosphor E, and the phosphor F can include any compound of nitride, Y₃AL₁₂:C, and fluoride. For example, the phosphor A can be gallium-doped yttrium aluminum garnet, such as yttrium trialuminum gallium pentaoxide [Y₃(Al, Ga)₅O₁₂], the phosphor B can be BaSi₂O₂N₂ (barium strontium dioxide dinitrogen, 1222), the phosphor C, the phosphor D, the phosphor E, and the phosphor F can be (Ca, Sr)AlSiN₃ (calcium strontium aluminum silicon nitrogen trioxide, 1113) or fluoride, such as K₂SiF₆:Mn⁴⁺ (potassium fluorosilicate). In addition, the phosphors of each emission wavelength of the phosphor A, the phosphor B, the phosphor C, the phosphor D, the phosphor E, and the phosphor F can be directly purchased from the market according to the emission wavelength.

It should be noted that the specific number of compounds included in any of the phosphors A, the phosphor B, the phosphor C, the phosphor D, the phosphor E, or the phosphor F is not limited, and can include only a single pure compound or a mixture of multiple compounds. For example, the phosphor B can also include a phosphor B1 and a phosphor B2, and the phosphor C can also include a phosphor C1, a phosphor C2, and a phosphor C3. In other embodiments, the phosphor B 1, the phosphor B2, the phosphor C1, the phosphor C2, and the phosphor C3 can also include a single pure compound or a mixture of multiple compounds. For example, the phosphor C1 can be (Ca, Sr)AlSiN₃, or a mixture of (Ca, Sr)AlSiN₃ and K₂SiF₆:Mn⁴⁺.

As shown in FIG. 6, in some embodiments, the fluorescent body includes a first fluorescent portion 321, a second fluorescent portion 322, and a third fluorescent portion 323 arranged in sequence along the light emission direction, the first fluorescent portion 321 includes a first phosphor, the second fluorescent portion 322 includes a second phosphor, and the third fluorescent portion 323 includes a third phosphor. In which, the first phosphor, the second phosphor, and the third phosphor are the first phosphor, the second phosphor, and the third phosphor of the above-mentioned application embodiment, which are not repeated here. The structure of each fluorescent portion in the embodiment can be determined according to specific situations. For example, when the blue light chip is vertically mounted on the substrate in a face-up manner, and the fluorescent body is a block structure that fills the entire reflective cup, the first fluorescent portion 321 can be a block structure that fills the bottom of the reflective cup by dispensing, the second fluorescent portion 322 can be a block structure that fills the middle of the reflective cup by dispensing on the upper surface of the first fluorescent portion 321, and the third fluorescent portion 323 can be a block structure that fills the top of the reflective cup by dispensing on the upper surface of the second fluorescent portion 322; when the fluorescent body is a film or layer structure, the first fluorescent portion 321, the second fluorescent portion 322, and the third fluorescent portion 323 can be laminated fluorescent films or fluorescent coatings, etc.

It should be noted that in the embodiment, each layer can contain one or more phosphors. When there are multiple phosphors, no chemical reaction occurs between different phosphors, and the properties of each phosphor remain unchanged. Only the type of light emitted through the layer increases with the increase of the type of the phosphors. If the first fluorescent portion 321 contains a kind of phosphor, when the light emitted by the blue light chip 310 passes through this layer, only this kind of phosphor is stimulated to emit light of the corresponding wavelength. If the first fluorescent portion 321 contains multiple kinds of phosphors, when the light emitted by the blue light chip 310 passes through this layer, each phosphor is stimulated to emit light of the corresponding wavelength. At this time, this layer emits multiple lights of different wavelengths. The principle of other fluorescent portions is the same. When the types of phosphor in each fluorescent portion are more, the types of light emitted are more, and finally all the light is mixed to form the near-natural light.

By making the first fluorescent portion 321, the second fluorescent portion 322 and the third fluorescent portion 323 respectively include the first phosphor, the second phosphor and the third phosphor, the ratio and concentration of the first phosphor, the second phosphor and the third phosphor can be flexibly adjusted during film formation, so that the generated white light spectrum is closer to the natural light. At the same time, compared with the three phosphor formulas mixed into one layer, the use of the fluorescent body provided in the embodiment can make the overall light loss of the light source relatively small and the light efficiency higher.

In some embodiments, the concentration of the first phosphor in the first fluorescent portion can be controlled to be 30-85%, further to be 40-75%, and furthermore to be 60-69%. The concentration of the first phosphor is the proportion of the first phosphor in the total mass of the first phosphor and the colloid.

The concentration of the second phosphor in the second fluorescent portion can also be controlled to be 30-85%, further to be 45-75%, and furthermore to be 60-69%. The concentration of the second phosphor is the proportion of the second phosphor in the total mass of the second phosphor and the colloid.

The concentration of the third phosphor in the third fluorescent portion can also be controlled to be 40-87%, further to be 50-80%, and furthermore to be 60-69%. The concentration of the first phosphor is the proportion of the third phosphor in the total mass of the third phosphor and the colloid.

The concentration of the first phosphor, the second phosphor, and the third phosphor determines the color temperature of the generated white light. The greater the concentration, the lower the color temperature under the conditions of a certain phosphor ratio and the thickness of the fluorescent portion, and the lower the concentration, the higher the color temperature.

In other embodiments, the fluorescent body includes a fourth fluorescent portion and a fifth fluorescent portion sequentially arranged along the light emission direction, the fourth fluorescent portion includes the first mixture, and the fifth fluorescent portion includes the second mixture. In which, the first mixture and the second mixture are the first mixture and the second mixture in the above-mentioned embodiment of the present application, which is not repeated here.

The structure of the fourth fluorescent portion and the fifth fluorescent portion in the embodiment is the same as the first fluorescent portion, the second fluorescent portion, and the third fluorescent portion, which can be determined according to the specific situation. When the blue light chip is vertically mounted on the substrate in a face-up manner, and the fluorescent body is a block structure that fills the entire reflective cup, the fourth fluorescent portion can be a block structure that fills the middle and lower part of the reflective cup by dispensing, and the fifth fluorescent portion can be a block structure that fills the middle and upper part of the reflective cup by dispensing on the upper surface of the fourth fluorescent portion; when the fluorescent body is a film or layer structure, the fourth fluorescent portion and the fifth fluorescent portion can be laminated fluorescent films or fluorescent coatings, etc..

In the white light source of the prior art, the optical power value of red light with a wavelength greater than 640nm is difficult to increase. The second mixture mainly produces red light. The proportion of the second mixture can be flexibly adjusted according to the light effect through the fourth fluorescent portion and the fifth fluorescent portion to increase the light power value of red light with a wavelength greater than 640nm in the white light generated by the full-color bionic fluorescent film of the embodiment of the present application, and improve the similarity between the white light and natural light. Compared with mixing two phosphor formulas into one layer, the use of the fluorescent body provided by this embodiment can make the overall light loss of the light source relatively small and the light effect higher, but the light effect of the fluorescent body provided by this embodiment is less than that of the fluorescent body provided by the first embodiment.

In some embodiments, the concentration of the first mixture in the fourth fluorescent portion can be controlled to be 40-85%, further to be 40-80%, and furthermore to be 40-75%. The concentration of the first mixture is the proportion of the first mixture in the total mass of the first mixture and the colloid. The concentration of the second mixture in the fifth fluorescent portion can also be controlled to be 15-85%, further to be 20-80%, and furthermore to be 30-75%. The concentration of the second mixture is the proportion of the second mixture in the total mass of the second mixture and the colloid.

Controlling the concentrations of the first mixture and the second mixture within this range can make the spectrum of different bands in the generated white light closer to the natural light.

In order to make the details and operations of the above embodiments of the present application clearly understood by those skilled in the art, the improved performance of the near-natural light LED light source in the above embodiments is significantly reflected, and the above technical scheme is illustrated by the following multiple embodiments.

### Embodiment 1 to Embodiment 4

The fluorescent body includes a first fluorescent portion, a second fluorescent portion, and a third fluorescent portion laminated in sequence. In which, the first fluorescent portion includes a first phosphor and a colloid, the second fluorescent portion includes a second phosphor and a colloid, and the third fluorescent portion includes a third phosphor and a colloid. The colloid is silica gel. The mass ratio of the first phosphor, the second phosphor, and the third phosphor is shown in Table 1 below. The fluorescent body is in the form of a fluorescent film.

The first phosphor includes a phosphor A2, and the phosphor A2 is Y₃(Al, Ga)₅O₁₂ with a emission wavelength of 490nm.

The second phosphor includes a phosphor B1 and a phosphor B2, the phosphor B1 is BaSi₂O₂N₂ with a emission wavelength of 525nm, and the phosphor B2 is BaSi₂O₂N₂ with a emission wavelength of 540nm. The mass ratio of the phosphor B1 and the phosphor B2 is shown in Table 1.

The third phosphor includes a phosphor C1, a phosphor C2, a phosphor C3, a phosphor D, a phosphor E, and a phosphor F. The phosphor C1 is (Ca, Sr) AlSiN₃ with an emission wavelength of 630nm, the phosphor C2 is (Ca, Sr) AlSiN₃ with an emission wavelength of 660nm, the phosphor C3 is (Ca, Sr) AlSiN₃ with an emission wavelength of 679nm, the phosphor D is (Ca, Sr) AlSiN₃ with an emission wavelength of 720nm, the phosphor E is (Ca, Sr) AlSiN₃ with an emission wavelength of 740nm, and the phosphor F is (Ca, Sr) AlSiN₃ with an emission wavelength of 795nm. The mass ratios of the phosphor C1, the phosphor C2, the phosphor C3, the phosphor D, the phosphor E, and the phosphor F are detailed in Table 1 below.

**Table 1**

| Items | mass ratio of phosphor B1(525nm) to phosphor B2(540nm) in the second phosphor | mass ratio of phosphor C1(630nm) phosphor C2(660nm), phosphor C3(679nm), phosphor D(720nm) Phosphor E(740nm) and phosphor F(795nm) in the third phosphor(C1:C2:C3:D:E:F) | mass ratio of first phosphor (A2,490nm), second phosphor, and third phosphor |
|---|---|---|---|
| Embodiment 1 | 50:45 | 12:15:23:50:35:25 | 45:45:40 |
| Embodiment 2 | 20:10 | 7:3:3:20:20:1 | 15:70:70 |
| Embodiment 3 | 20:85 | 7:30:40:80:50:50 | 70:15:13 |
| Embodiment 4 | 85:10 | 20:30:40:30:30:15 | 30:50:45 |

The film forming methods of each fluorescent portion in Embodiments 1 to 4, the film thickness of the first phosphor and the concentration of the first fluorescent portion, the film thickness of the second phosphor and the concentration of the second fluorescent portion, and the film thickness of the third phosphor and the concentration of the third fluorescent portion are detailed in Table 3.

### Embodiment 5 to Embodiment 8

The fluorescent body includes a fourth fluorescent portion and a fifth fluorescent portion. The fourth fluorescent portion includes a colloid and a first mixture, and the fifth fluorescent portion includes a colloid and a second mixture. The colloid is silica gel. The first mixture includes a phosphor A2, a phosphor B3, and a phosphor C2, and their mass ratios are detailed in Table 2. In which, the phosphor B3 is BaSi₂O₂N₂ with a emission wavelength of 535nm, and the phosphor A2 and the phosphor C2 are the same as the phosphor A2 and the phosphor C2 in Embodiment 1. The fluorescent body is in the form of a fluorescent film.

The second mixture includes a phosphor D, a phosphor E, and a phosphor F, and their mass ratios are detailed in Table 2. In which, the phosphor D, the phosphor E, and the phosphor F are the same as the phosphor D, the phosphor E, and the phosphor F in Embodiment A1.

**Table 2**

| items | First mixture | | mass ratio of phosphor D(720nm) Phosphor E(740nm) to phosphor F(795nm) in the second mixture (D:E:F) |
|---|---|---|---|
| Embodiment 5 | mass ratio of phosphor A2(490nm), phosphor B3(535nm) and phosphor C2(660nm) (A:B3:C2) | 38:50:15 | 65:40:35 |
| Embodiment 6 | | 15:85:30 | 40:60:70 |
| Embodiment 7 | | 60:20:1 | 90:20:1 |
| Embodiment 8 | | 80:85:40 | 120:90:100 |

In the film forming methods of the fluorescent portions in Embodiments 5 to 8, the film thickness of the first mixed concentration of the fourth fluorescent portion, and the film thickness of the second mixed concentration of the fifth fluorescent portion are detailed in Table 3.

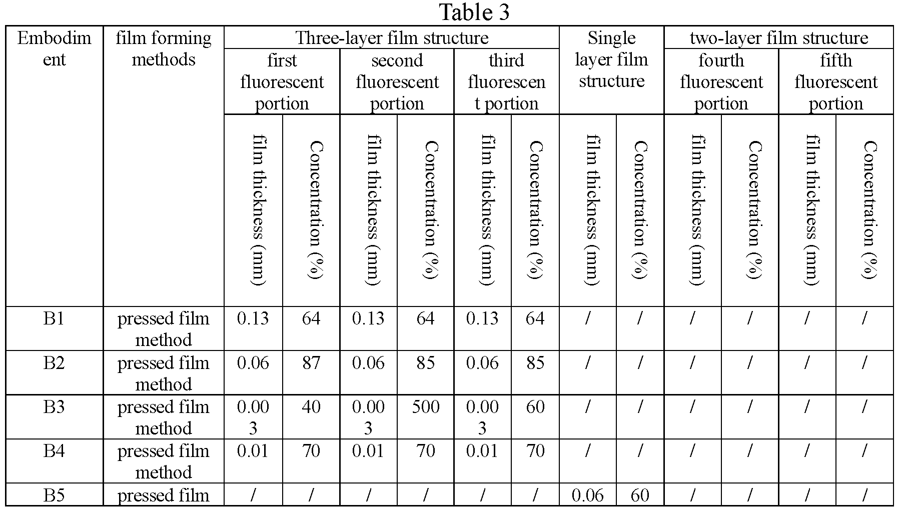

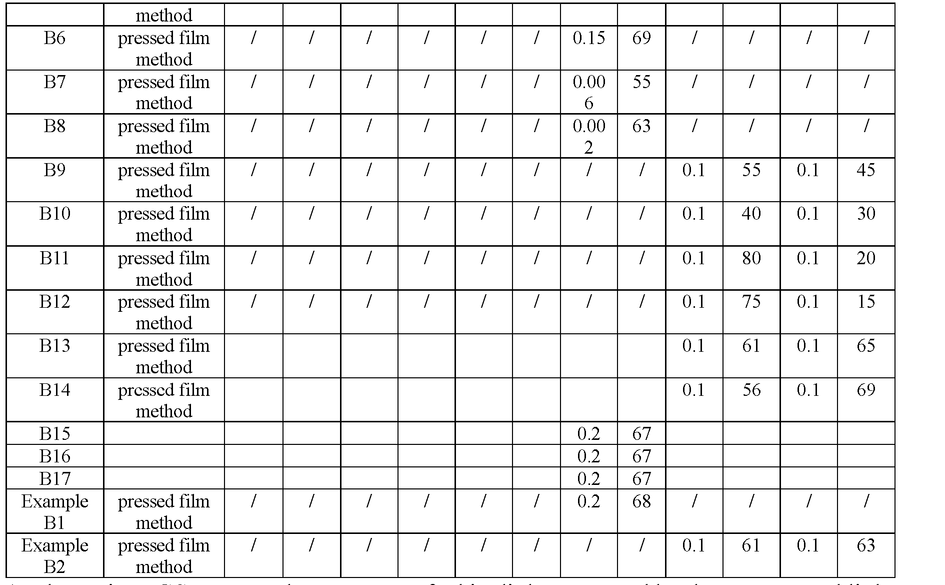

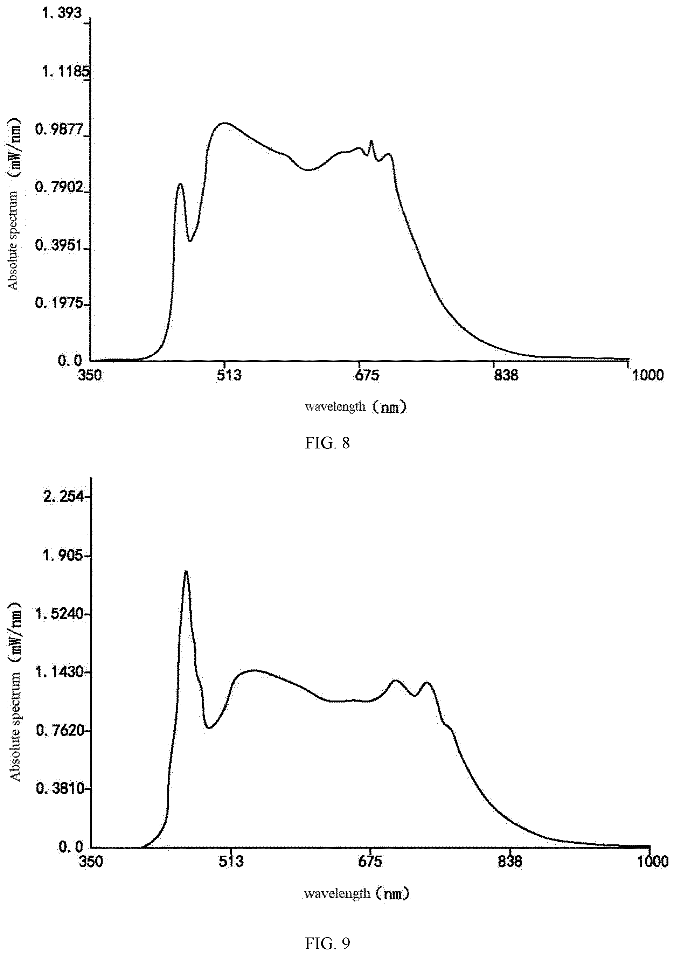

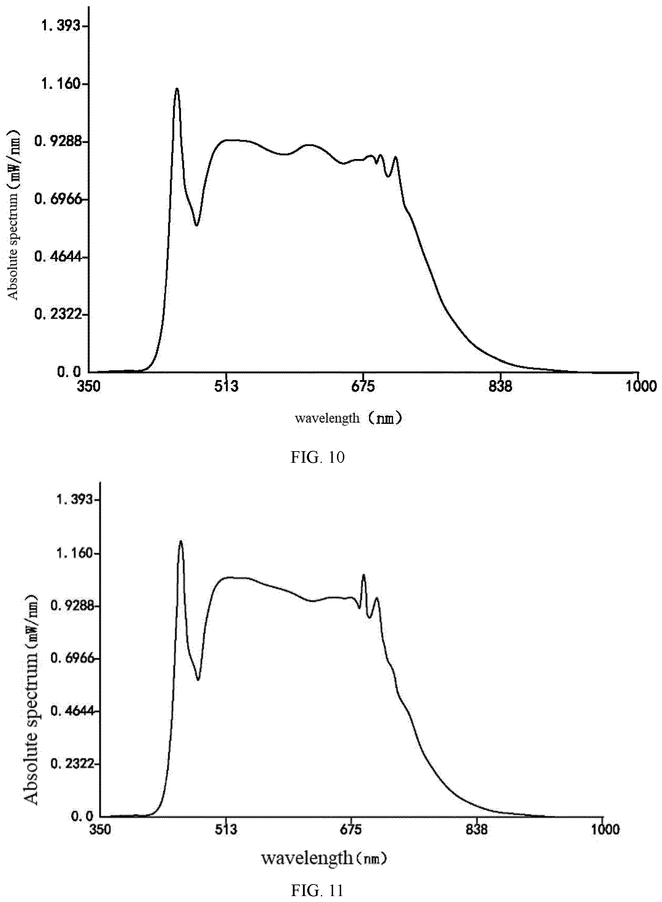

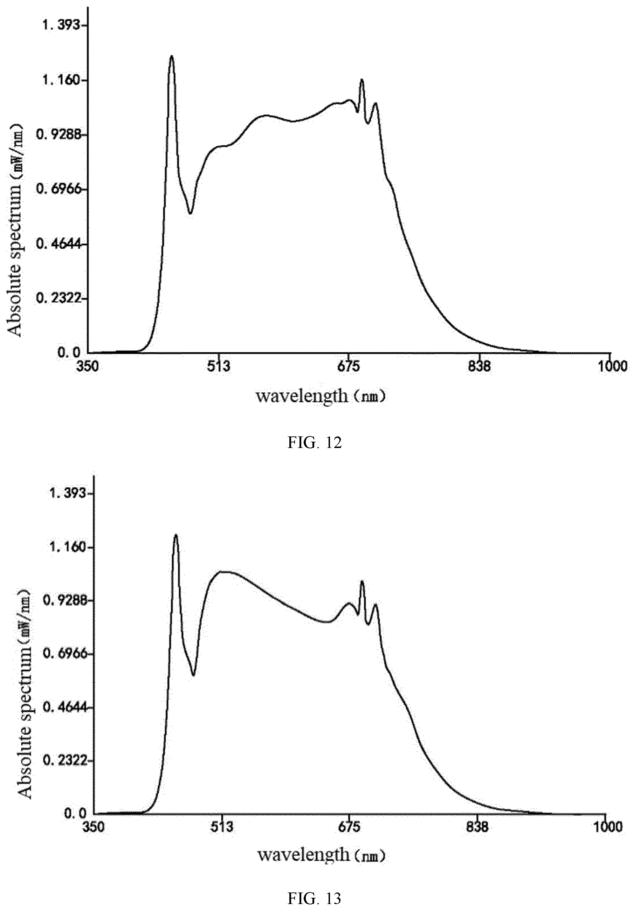

As shown in FIGS. 7 to 14, the spectrum of white light generated by the near-natural light LED light source provided in Embodiments 1 to 8 of the present application is highly similar to the natural light. The white light includes all visible light in the 400-700nm band, and the absolute optical power value of the purple light in the 380-435nm band is small, the absolute optical power value of the cyan light in the 475-492nm band is large, and the absolute optical power value of the cyan light in the 475-492nm band is large. The optical powers of visible light in different bands are close to that of the natural light, so that the white light highly simulates the natural light, the color rendering index is high, the harmful to the human body is less, so that the human body feels comfortable.

In an optional embodiment, the refractive index of each fluorescent portion arranged along the light emission direction increases successively, that is, in the second embodiment of the above-mentioned fluorescent body, the refractive index of the first fluorescent portion and the second fluorescent portion increases successively, and in the third embodiment of the above-mentioned fluorescent body, the refractive index of the first fluorescent portion, the second fluorescent portion, and the third fluorescent portion increases successively, so that the emission angle of the light emitted by the blue light chip gradually increases, and then the emission angle of the light emitted by each light-emitting unit is large enough to meet the use requirements.

As shown in FIG. 15, the fluorescent body generally includes a colloid 3211 and a phosphor 3212 mixed inside the colloid 3211, and the thickness of the fluorescent body is generally greater than 2 times or even more times the particle size of the phosphor, that is, the thickness of each of the above-mentioned fluorescent portions is generally greater than 2 times or even more times the particle size of the phosphor inside it, so that there is often a phenomenon in the fluorescent body that some phosphors are located on the propagation path of the light emitted by other phosphors, so that the light emitted by some phosphors after being excited will be blocked by other phosphors during the emission process and reflected and deviated from the original emission path, therefore the light emission effect and light efficiency of the light source is affected. In order to solve this problem, in an optional embodiment, the thickness d1 of each of the above-mentioned fluorescent portions is greater than the particle size of any one of the phosphors, and less than 1.5 times the maximum particle size of a phosphor in the fluorescent portion. That is, as shown in FIG. 15, the thickness d1 of the first fluorescent portion 321 is greater than the particle size d2 of a single phosphor 3212 therein, and less than 1.5 times the particle size d2 of a single phosphor; the thickness of the second fluorescent portion 322 is greater than the particle size of a single phosphor therein, and less than 1.5 times the particle size of a single phosphor; the thickness of the third fluorescent portion 323 is greater than the particle size of a single phosphor therein, and less than 1.5 times the particle size of a single phosphor.

It should be noted that, since different types of phosphors may have different particle sizes when they are arranged in a single fluorescent portion, the particle size greater than any one of the phosphors mentioned above refers to the particle size greater than the largest phosphor in the fluorescent portion, and similarly, the particle size less than 1.5 times the largest phosphor in the fluorescent portion also refers to the particle size less than 1.5 times the largest phosphor in the fluorescent portion.

In this way, the thickness d1 of each fluorescent portion is very thin, so that almost all the phosphors therein are dispersed and laid flat on a layer, that is, no phosphor is located on the propagation path of the light emitted by other phosphors, so that the light emitted by each phosphor can be smoothly emitted through the light-emitting surface of the fluorescent body, the light emitted by each phosphor is then mixed with the light emitted by the blue light chip to form a preset spectrum, so that the spectrum of the light emitted by the light source is the preset spectrum, and the light efficiency is high.

In an optional embodiment, as shown in FIG. 6, the thickness d3 of the fluorescent body 320 is less than or equal to 0.3 mm. The existing fluorescent body is generally thicker, which is not conducive to the heat dissipation of the light source and makes the light source thicker. The fluorescent body adopts the thickness specified in the embodiment, which can make the light source thinner and is conducive to the heat dissipation of the blue light chip 310.

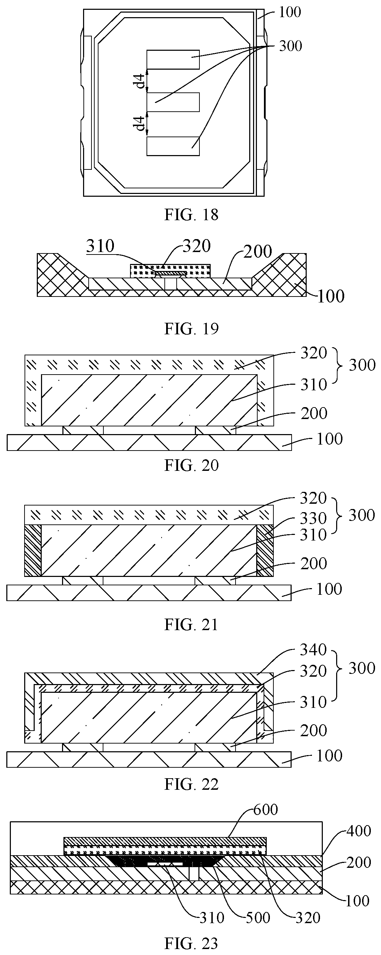

In an optional embodiment, as shown in FIG. 18, the spacing d4 between two adjacent light-emitting units 300 is greater than the thickness of the fluorescent body, so as to reduce the risk of light emitted by any light-emitting unit 300 being blocked by the adjacent light-emitting unit 300 and affecting the light output efficiency, so that the light output efficiency of the light source is higher.

Studies have shown that, with the formula and concentration unchanged, the greater the thickness of the fluorescent body, the lower the color temperature. Based on this, when the color temperature does not meet the requirements, the color temperature can be adjusted by changing the thickness, and the impact on other parameters is small. By adjusting the formula or thickness of the fluorescent body, the spectrum of the light emitted by the light source (400nm-700nm) can be made 95% similar to the natural spectrum of the same color temperature. The near-natural light has the following optical parameters:
when the color temperature of the near-natural light is 2700K-3000K, the absolute spectral power of the 380-435nm band is less than 0.35; the absolute spectral power of the 435-475nm band is greater than 0.40; the absolute spectral power of the 475-492nm band is greater than 0.45; the absolute spectral power of the 492-577nm band is greater than 0.50; the absolute spectral power of the 577-597nm band is greater than 0.75; the absolute spectral power of the 597-622nm band is greater than 0.80; and the absolute spectral power in the 622-700nm band is greater than 0.80;
when the color temperature of the near-natural light is 4000K-4200K, the absolute spectral power of the 380-435nm band is less than 0.40; the absolute spectral power of the 435-475nm band is less than 0.65; the absolute spectral power of the 475-492nm band is greater than 0.60; the absolute spectral power of the 492-577nm band is greater than 0.65; the absolute spectral power of the 577-597nm band is greater than 0.80; the absolute spectral power of the 597-622nm band is greater than 0.8; and the absolute spectral power in the 622-700nm band is greater than 0.80;
when the color temperature of the near-natural light is 5500K-6000K, the absolute spectral power of the 380-435nm band is less than 0.45; the absolute spectral power of the 435-475nm band is less than 0.80; the absolute spectral power of the 475-492nm band is greater than 0.70; the absolute spectral power of the 492-577nm band is greater than 0.80; the absolute spectral power of the 577-597nm band is greater than 0.80; the absolute spectral power of the 597-622nm band is greater than 0.80; and the absolute spectral power in the 622-700nm band is greater than 0.70;
when the color temperature of the near-natural light is less than 4000K, the absolute spectral power of the 380-435nm band is less than 0.40; the absolute spectral power of the 435-475nm band is less than 0.65; the absolute spectral power of the 475-492nm band is greater than 0.30; the absolute spectral power of the 492-577nm band is less than 0.7; the absolute spectral power of the 577-597nm band is less than 0.80; the absolute spectral power of the 597-622nm band is greater than 0.8; and the absolute spectral power of the 622-700nm band is greater than 0.80.

In the above embodiments, one blue light chip can be arranged in each light-emitting unit, or two or more blue light chips can be arranged in each light-emitting unit, and the number of blue light chips in each light-emitting unit can be the same or different. The peak wavelength of each blue light chip is 440-475nm, preferably 440-460nm.

When the same light-emitting unit includes multiple blue light chips, the peak wavelengths of all blue light chips in the same light-emitting unit are consistent, or the difference in peak wavelengths of any two blue light chips is within a preset range. The preset range mentioned here can be set according to the voltage difference required for different blue light chips to produce light with the same peak wavelength within 0.1V.

With this structure, different blue light chips in the same blue light chip can use the same wavelength conversion element, which can ensure that the light output effect of different areas of a single light-emitting unit are consistent, which is convenient for the spectrum design and processing of a single light-emitting unit. In addition, compared with providing one blue light chip in each light-emitting unit, providing multiple blue light chips in a single light-emitting unit, that is, including multiple blue light chips in a single blue light chip, can make the short-wave band of the spectrum formed by the entire light source smoother.

In an optional embodiment, the length of a single wavelength conversion element is less than or equal to 4.0 mm, and the width is less than or equal to 3.0 mm. The single light-emitting unit adopts this size, which is small in size, so that the volume of the entire light source can be smaller.

Regarding the mounting method of the chip, as shown in FIGS. 16 to 19, it is preferred to flip the blue light chip 310 on the surface of the substrate 100, which is conducive to the effective connection between the blue light chip 310 and the electrical connector 200 on the substrate 100, and is conducive to efficient heat dissipation. The blue light chip 310 can be uniformly filmed by equipment to ensure that the fluorescent film of different products has good consistency, thereby avoiding the problem of poor consistency caused by the dispensing process of the face-up chip, and at the same time, different products are in the same BIN position when the color temperature is the same, with good color temperature consistency and low cost. In addition, the flip chip also further reduces the volume of the light-emitting unit 300, which is conducive to the control of the size of the light source.

The present application is not limited to the use of flip chips, and the use of face-up chips is also feasible, that is, the blue light chip 310 can also be mounted on the surface of the substrate 100. When the blue light chip 310 is mounted on the surface of the substrate 100, the operation is simple and the structure is stable.

In an optional embodiment, as shown in FIGS. 16 and 17, the wavelength conversion element 320 is a fluorescent film, and the fluorescent film is formed on the light-emitting surface of the blue light chip 310 by spraying. By adopting this structure, the thickness of the wavelength conversion element 320 can be reduced, and the volume of the light-emitting unit 300 can be reduced, which is conducive to the control of the size of the light source.

In an optional embodiment, as shown in FIGS. 18 and 19, the blue light chip 310 is mounted on the substrate 100 through the CSP packaging process. CSP (Chip Scale Package) packaging is the latest generation of memory chip packaging technology, which uses a die bonder and reflow soldering process technology to directly bond the blue light chip 310 to the substrate 100. By adopting this structure, the packaging volume of the light-emitting unit 300 can be controlled to be the same as the volume of the internal blue light chip 310, or the packaging volume is not more than 20% of the chip volume. Because the structure omits materials and processes such as reflective cups, brackets, and gold wires, the material and process links are greatly reduced, so it is also called a package-free LED. At the same time, with this structure, each light-emitting unit 300 can flexibly make any combination of different spectra, such as 600nm-700nm, 500nm-600nm and other wide-spectrum color light sources, and can also highlight a certain wavelength spectrum in a single white light 400nm-700nm continuous spectrum, such as a 650nm single-wavelength spectrum with high light power, or a 650nm-660nm wide spectrum with high light power, or a 500nm-700nm wide spectrum with high light power, etc., which can be used exclusively for physical therapy or special efficacy products; and the limitations of the narrow spectrum of LED physical therapy color light sources are broken through.

Specifically, when the blue light chip 310 is mounted on the substrate 100 through the CSP packaging process and the wavelength conversion element 320 uses a fluorescent film, there are three main packaging methods: as shown in FIG. 20, the first one is to use a fluorescent film to cover the top and four sides of the flip-chip blue light chip 310 to form a five-sided light-emitting CSP structure. This structure has high light efficiency, but the color temperature consistency control of the top and the surroundings is poor; as shown in FIG. 21, the second one is to firstly coat the side of the blue light chip 310 with a protective layer 330, and then coat the top of the blue light chip with a fluorescent film. There is only one light-emitting surface at the top, and the consistency and directivity of the light are better, but the light output of the surroundings is lost, and the light efficiency will be lower; as shown in FIG. 22, the third one is to coat a layer of ultra-thin fluorescent film on the flip-chip blue light chip 310 and then add a transparent encapsulation layer 340 for fixed molding. It also has five-sided light emission, the light efficiency is high, and the light color uniformity is well, but the process requirements are high and complex. The first packaging method is preferred in the present application.

In an optional embodiment, as shown in FIGS. 1 and 2, a reflective cup 400 is provided on the substrate 100, the light-emitting unit 300 is arranged in the reflective cup 400 , and the electrical connector 200 is formed on the surface of the substrate 100 and connected to the blue light chip 310 at the bottom of the reflective cup 400.

Specifically, the inner wall of the reflective cup 400 in the embodiment is provided with a reflective surface, which is used to reflect the blue light, and the encapsulation colloid is used to protect the internal structure of the reflective cup 400 and make the structure of the light-emitting unit 300 more stable, and to adjust the refraction of the light. The light emitted by the light-emitting unit 300 is fully mixed and then output through the encapsulation colloid. The electrical connector 200 is formed on the surface of the substrate 100, and positive and negative pins are formed outside the reflective cup 400 for connecting the power supply, and part of the electrical connector 200 is exposed at the bottom of the reflective cup 400 for connecting to the light-emitting unit 300. With this structure, the light source has a higher light efficiency. In the embodiment, the wavelength conversion element can be formed in the reflective cup by dispensing, or it can be arranged outside the reflective cup, which can be flexibly selected according to design needs.

In the above embodiments, the fluorescent body can be directly coated on the surface of the blue light chip 310, but about 60% of the blue light emitted by the blue light chip 310 will be absorbed by the blue light chip 310 after being backscattered by the phosphor, resulting in a decrease in the blue light emission efficiency, that is, the lighting efficiency of the blue light chip 310 is reduced, and the temperature of the blue light chip 310 will increase as the working time of the blue light chip 310 increases, and the fluorescent body is closely attached to the blue light chip 310, which can easily cause the fluorescent material in the fluorescent body to age due to heat and increase the light decay. In some embodiments, as shown in FIG. 2, a first encapsulation layer 500 is filled between the blue light chip 310 and the wavelength conversion element 320 in each light-emitting unit 300. Specifically, the first encapsulation layer 500 is coated on the light-emitting surface of the blue light chip 310, and the fluorescent body is formed on the light-emitting surface of the first encapsulation layer 500. The first encapsulation layer 500 in the embodiment can be made of a light-transmitting material such as silicone and resin, as long as it does not affect the propagation of light. The first encapsulation layer 500 can prevent the fluorescent body from directly contacting the blue light chip 310 , and effectively solve the light decay, heat dissipation and aging problems of the fluorescent material.

In other embodiments, as shown in FIG. 23, a first encapsulation layer 500 is filled between the blue light chip 310 and the wavelength conversion element 320 in each light-emitting unit 300, and the light-emitting surface of the wavelength conversion element 320 is coated with a second encapsulation layer 600. Specifically, the first encapsulation layer 500 is coated on the light-emitting surface of the blue light chip 310, the fluorescent body is formed on the light-emitting surface of the first encapsulation layer 500, and the second encapsulation layer 600 is formed on the light-emitting surface of the fluorescent body. In the embodiment, the first encapsulation layer 500 and the second encapsulation layer 600 can be made of light-transmitting materials such as silicone and resin, respectively, and the materials of the two can be the same or different, and can be flexibly selected according to the needs of use. The providing of the first encapsulation layer 500 can avoid direct contact between the fluorescent body and the blue light chip 310, and effectively solve the light decay, heat dissipation and aging problems of the fluorescent material. The providing of the second encapsulation layer 600 can effectively protect the fluorescent body, reduce the risk of wear of the fluorescent body during use, and the risk of light decay and aging of the fluorescent material when the external temperature is too high, which can effectively increase the service life of the fluorescent body.

In a specific embodiment, the first encapsulation layer 500 and the second encapsulation layer 600 are both made of silica gel, the wavelength conversion element 320 is a fluorescent body, and the reflective cup 400 is mounted on the substrate 100, the blue light chip 310 in the light-emitting unit 300 is mounted on the bottom of the reflective cup 400 and is electrically connected to the electrical connector 200 on the substrate 100, the blue light chip 310 is covered with the first encapsulation layer 500, the first encapsulation layer 500 is covered with a fluorescent body, and the fluorescent body is covered with the second encapsulation layer 600. In the embodiment, the upper surface of the first encapsulation layer 500 is flush with the upper surface of the reflective cup 400, and the fluorescent body and the second encapsulation layer 600 are located outside the reflective cup 400. In other embodiments, at least one of the fluorescent body and the second encapsulation layer 600 can also be arranged in the reflective cup 400.

There are multiple mounting methods for the light-emitting assembly in the above embodiments. In some embodiments, as shown in FIGS. 1 and 16, the light-emitting assembly includes three light-emitting units 300 spaced apart and distributed in a triangular shape. For example, the three light-emitting units 300 in the same light-emitting assembly can be packaged in a 3535, 5050 or other manners to form a triangular layout. In other embodiments, as shown in FIG. 18, all the light-emitting units 300 in the same light-emitting assembly are arranged in a straight line, and a 5630 packaging manner can be specifically adopted. Both of the above methods can meet the light emission requirements of the light source, and the structure is simple and easy to be mounted.

In another embodiment of the present application, an illuminating device is provided, including the near-natural light LED light source provided in the above embodiments, which can achieve the same technical effect as the above examples, and will not be repeated here.

The above description is only a preferred example of the present application, and only specifically describes the technical principle of the present application. These descriptions are only for explaining the principle of the present application and cannot be interpreted as limiting the scope of protection of the present application in any way. Based on the explanation here, any modifications, equivalent substitutions and improvements made within the spirit and principles of the present application, as well as other specific implementation methods of the present application that can be associated with the technical personnel in this field without creative work, should be included in the scope of protection of the present application.

## Claims

1. A near-natural light LED light source, **characterized by** comprising:
a substrate,
at least one light-emitting assembly, arranged on the substrate, and
an electrical connector, electrically connected to the light-emitting assembly,
wherein the light-emitting assembly comprises at least three light-emitting units, each light-emitting unit comprises a blue light chip and a wavelength conversion element formed on a light-emitting side of the blue light chip, peak wavelengths of at least two of the blue light chips in a same light-emitting assembly differ by more than 3nm, light emitted by all of the light-emitting units in the same light-emitting assembly are mixed to form a near-natural light with a wavelength of 400-700nm, and an absolute spectral power of a 640-700nm band in the near-natural light is greater than 0.7.

2. The near-natural light LED light source according to claim 1, **characterized in that**, peak wavelengths of all the blue light chips in the same light-emitting assembly are different, and a peak wavelength interval between any two of the blue light chips is more than 3nm.

3. The near-natural light LED light source according to claim 1, **characterized in that**, each light-emitting unit enables to emit near-natural light with a wavelength of 400-700nm.

4. The near-natural light LED light source according to claim 1, **characterized in that**, the wavelength conversion element comprises a fluorescent body.

5. The near-natural light LED light source according to claim 4, **characterized in that**, a fluorescent composition is mixed in the fluorescent body, and the fluorescent composition comprises:
a first phosphor, wherein an emission wavelength of the first phosphor is 480-500nm;
a second phosphor, wherein an emission wavelength of the second phosphor is greater than 500nm and less than 620nm;
a third phosphor, wherein an emission wavelength of the third phosphor is greater than or equal to 620nm; and
a mass ratio of the first phosphor, the second phosphor, and the third phosphor is (15-70): (15-70): (13-70).

6. The near-natural light LED light source according to claim 5, **characterized in that**,
the first phosphor comprises a phosphor A, and an emission wavelength of the phosphor A is 488-492nm;
the second phosphor comprises a phosphor B, and an emission wavelength of the phosphor B is 523-542nm;
the third phosphor comprises a phosphor C, a phosphor D, a phosphor E, and a phosphor F; an emission wavelength of the phosphor C is 628-681nm, an emission wavelength of the phosphor D is 718-722nm, an emission wavelength of the phosphor E is 738-742nm, and an emission wavelength of the phosphor F is 793-797nm.

7. The near-natural light LED light source according to claim 6 is **characterized in that**, the first phosphor, the second phosphor, and the third phosphor are arranged separately;
the phosphor B in the second phosphor comprises a phosphor B1 and a phosphor B2; an emission wavelength of the phosphor B1 is 523-527nm, an emission wavelength of the phosphor B2 is 538-542nm, and a mass ratio of the phosphor B1 to the phosphor B2 is (20-85): (10-85); and
the phosphor C in the third phosphor comprises a phosphor C1, a phosphor C2, and a phosphor C3; an emission wavelength of the phosphor C1 is 628-632nm, an emission wavelength of the phosphor C2 is 658-662nm, and an emission wavelength of the phosphor C3 is 677-681nm; a mass ratio of the phosphor C1, the phosphor C2, the phosphor C3, the phosphor D, the phosphor E, and the phosphor F is (3-35): (1-45): (3-60): (7-90): (7-60): (1-70).

8. The near-natural light LED light source according to claim 6, **characterized in that**, the phosphor C in the third phosphor, the first phosphor and the second phosphor form a first mixture;
the phosphor D, the phosphor E, and the phosphor F in the third phosphor form a second mixture,
a mass ratio of the phosphor A, the phosphor B, and the phosphor C in the first mixture is (10-80): (15-85): (1-40);
a mass ratio of the phosphor D, the phosphor E, and the phosphor F in the second mixture is (20-120): (10-90): (1-100); and
the first mixture and the second mixture are arranged separately.

9. The near-natural light LED light source according to claim 5, **characterized in that**, the fluorescent body comprises a first fluorescent portion, a second fluorescent portion, and a third fluorescent portion sequentially arranged along a light emission direction, the first fluorescent portion comprises the first phosphor, the second fluorescent portion comprises the second phosphor, and the third fluorescent portion comprises the third phosphor.

10. The near-natural light LED light source according to claim 8, **characterized in that**, the fluorescent body comprises a fourth fluorescent portion and a fifth fluorescent portion sequentially arranged along a light emission direction, the fourth fluorescent portion comprises the first mixture, and the fifth fluorescent portion comprises the second mixture.

11. The near-natural light LED light source according to claim 9 or 10, **characterized in that**, a refractive index of each fluorescent portion arranged along the light emission direction increases sequentially.

12. The near-natural light LED light source according to claim 9 or 10, **characterized in that**, a thickness of each fluorescent portion is greater than a particle size of any one of the phosphors, and less than 1.5 times a maximum particle size of a phosphor in the fluorescent portion.

13. The near-natural light LED light source according to any one of claims 4 to 10, **characterized in that**, a thickness of the fluorescent body is less than or equal to 0.3 mm.

14. The near-natural light LED light source according to any one of claims 4 to 10, **characterized in that**, a spacing between two adjacent light-emitting units is greater than a thickness of the fluorescent body.

15. The near-natural light LED light source according to any one of claims 1 to 10, **characterized in that**, the near-natural light has following optical parameters:
when a color temperature of the near-natural light is 2700K-3000K, an absolute spectral power of a 380-435nm band is less than 0.35; an absolute spectral power of a 435-475nm band is greater than 0.40; an absolute spectral power of a 475-492nm band is greater than 0.45; an absolute spectral power of a 492-577nm band is greater than 0.50; an absolute spectral power of a 577-597nm band is greater than 0.75; an absolute spectral power of a 597-622nm band is greater than 0.80; and an absolute spectral power of a 622-700nm band is greater than 0.80;
when the color temperature of the near-natural light is 4000K-4200K, the absolute spectral power of the 380-435nm band is less than 0.40; the absolute spectral power of the 435-475nm band is less than 0.65; the absolute spectral power of the 475-492nm band is greater than 0.60; the absolute spectral power of the 492-577nm band is greater than 0.65; the absolute spectral power of the 577-597nm band is greater than 0.80; the absolute spectral power of the 597-622nm band is greater than 0.8; and the absolute spectral power of the 622-700nm band is greater than 0.80;
when the color temperature of the near-natural light is 5500K-6000K, the absolute spectral power of the 380-435nm band is less than 0.45; the absolute spectral power of the 435-475nm band is less than 0.80; the absolute spectral power of the 475-492nm band is greater than 0.70; the absolute spectral power of the 492-577nm band is greater than 0.80; the absolute spectral power of the 577-597nm band is greater than 0.80; the absolute spectral power of the 597-622nm band is greater than 0.80; and the absolute spectral power in the 622-700nm band is greater than 0.70; and
when the color temperature of the near-natural light is less than 4000K, the absolute spectral power of the 380-435nm band is less than 0.40; the absolute spectral power of the 435-475nm band is less than 0.65; the absolute spectral power of the 475-492nm band is greater than 0.30; the absolute spectral power of the 492-577nm band is less than 0.7; the absolute spectral power of the 577-597nm band is less than 0.80; the absolute spectral power of the 597-622nm band is greater than 0.8; and the absolute spectral power of the 622-700nm band is greater than 0.80.

16. The near-natural light LED light source according to any one of claims 1 to 10, **characterized in that**, a same light-emitting unit comprises a plurality of blue light chips, and the peak wavelengths of all the blue light chips in the same light-emitting unit are consistent, or a difference in the peak wavelengths of any two blue light chips is within a preset range.

17. The near-natural light LED light source according to any one of claims 1 to 10, **characterized in that**, the blue light chips are mounted on a surface of the substrate in a flip-chip manner.

18. The near-natural light LED light source according to claim 17, **characterized in that**, the wavelength conversion element is a fluorescent film, and the fluorescent film is formed on a light-emitting surface of the blue light chip by spraying.

19. The near-natural light LED light source according to claim 17, **characterized in that**, the blue light chips are mounted on the substrate by a CSP packaging process.

20. The near-natural light LED light source according to any one of claims 1 to 10, **characterized in that**, the blue light chips are mounted on a surface of the substrate layer in a face-up manner.

21. The near-natural light LED light source according to claim 20, **characterized in that**, a reflective cup corresponding to each of the light-emitting units is provided on the substrate, each of the light-emitting units is arranged in one corresponding reflective cup, and the electrical connector is formed on the surface of the substrate and connected to the blue light chip at a bottom of the reflective cup.

22. The near-natural light LED light source according to claim 21, **characterized in that**, a first encapsulation layer is filled between the blue light chip and the wavelength conversion element in each of the light-emitting units; or
a first encapsulation layer is filled between the blue light chip and the wavelength conversion element in each of the light-emitting units, and a light-emitting surface of the wavelength conversion element is covered with a second encapsulation layer.

23. The near-natural light LED light source according to any one of claims 1 to 10, **characterized in that**, the light-emitting assembly comprises the three light-emitting units that are spaced apart and distributed in a triangular shape; or
all the light-emitting units in the same light-emitting assembly are arranged in a straight line.

24. An illuminating device, **characterized in that** comprising the near-natural light LED light source according to any one of claims 1 to 23.
